# EUROPEAN PATENT SPECIFICATION

(11) **EP 3 851 286 B1**
(45) Date of publication and mention of the grant of the patent: **08.03.2023**
(21) Application number: 21160187.7
(22) Date of filing: 07.01.2014
(51) Int. Cl.: B41J 2/175

(54) **SHORT-CIRCUIT DETECTION METHOD OF INK CARTRIDGE CHIP, CHIP, INK CARTRIDGE AND RECORDING DEVICE**
KURZSCHLUSSERKENNUNGSVERFAHREN FÜR TINTENKARTUSCHENCHIP, CHIP, TINTENKARTUSCHE UND AUFZEICHNUNGSVORRICHTUNG
PROCÉDÉ DE DÉTECTION DE COURT-CIRCUIT DE PUCE DE CARTOUCHE D'ENCRE, PUCE, CARTOUCHE D'ENCRE ET DISPOSITIF D'ENREGISTREMENT

(30) Priority: 22.05.2013 CN 201310192677
(43) Date of publication of application: 21.07.2021
(62) Divisional of application: 18178342.4
(73) Proprietor: Geehy Microelectronics Inc., Zhuhai, Guangdong 519060 (CN)
(72) Inventor: LIU, Weichen, Zhuhai, Guangdong 519060 (CN)
(74) Representative: Dr. Gassner & Partner mbB

(56) References cited:
- US-A1- 2012 056 920
- US-A1- 2012 127 239

## Description

### TECHNICAL FIELD

The present invention relates to detection technology for a recording device, and more particularly, to an ink cartridge chip, an ink cartridge and a recording device.

### BACKGROUND

Currently, recording devices are common tools used in daily life and work. There are variety of types of recording devices such as a printer, a copier, a facsimile machine, which can display recorded information on the paper through an imaging material. The recording device mainly includes a recording device body and a detachable ink cartridge. The recording device body may have different designs depending on sources of the recording information and imaging modes. The ink cartridge is the ink cartridge having general meaning.

In order to enable the recording device to judge whether the mounted ink cartridge is proper, the ink cartridge is often provided with a chip. A storage element used to store ink cartridge related information, such as ink type, ink residual, ink consumption, is provided on the chip. Once the ink cartridge is mounted onto the recording device, an electrical connection between the chip and the recording device body is established for real-time data exchange, so as to guarantee some variable information in the ink cartridge, such as ink residual or ink consumption, can update in real time. Particularly, the electrical connection between the ink cartridge and the recording device body is often achieved by terminals, For example, the chip of the ink cartridge is usually provided with a power supply terminal (VCC), a data terminal (DATA), a clock terminal (CLK), a reset terminal (RST), a ground terminal (VDD), etc., and each of the terminals is connected with the storage element of the ink cartridge.

However, the existing ink cartridge has problems as follows: since liquid droplets or dusts fall between two terminals with a voltage difference. For example, short circuit is easy to occur between the power supply terminal and the ground terminal, resulting in damage to the storage element.

Furthermore, with the development of recording technology, in addition to the storage element, the ink cartridge is provided with other apparatus, such as a high-voltage or low-voltage circuit applied with a higher or lower voltage than the drive voltage of the storage element, a piezoelectric sensor or an induction coil for detecting the ink residual. In this case, since the electrical connection between the ink cartridge and the recording device is often achieved by terminals as described above, for this type of container, there is a risk of short circuit between a plurality of terminals for one apparatus and a plurality of terminals for another apparatus, and such short circuit may cause damage to the ink cartridge or the recording device.

Obviously, in order to avoid the ink cartridge or the recording device being damaged, it is necessary to detect the occurrence of the short circuit in advance. In the prior art, it has been proposed that a short-circuit detection circuit is provided on the recording device, then the short-circuit detection circuit on the recording device side can judge whether short circuit occurs on the connecting terminal on the ink cartridge chip by detecting voltage change of the terminal on the recording device side. However, the short-circuit detection described above is taken upon completion of the installation detection of the ink cartridge on the recording device, at this time, even if the short circuit is detected, the storage element may have been damaged, and thus the ink cartridge cannot be used any more.

Moreover, since the short-circuit detection circuit is provided on the recording device, for recording devices available in the market and without the short-circuit detection circuit, even if two types of recording devices are applicable to the same ink cartridge, the recording device without the short-circuit detection circuit also has a safety risk that the recording device or the ink cartridge chip may be damaged due to failing to detect short circuit timely.

US 2012-0056920 A1 discloses that a detection process of a mounted state is performed to detect loose contacts caused by such inclination of the cartridge or detect an unintended short circuit or leakage caused by foreign matter.

US 2012-0127239 A1 discloses a circuit substrate, including a third terminal which is connected to an overvoltage detection section provided in the printer in order to detect high voltage which is applied to the third terminal by a short circuit of the second terminal and the third terminal.

### SUMMARY

The present invention is defined by independent claims. Additional features of the invention are presented in the dependent claims. In the following, parts of the description and drawings referring to embodiments, which are not covered by the claims, are not presented as embodiments of the invention, but as examples useful for understanding the invention.

The present invention provides a short-circuit detection method of an ink cartridge chip, an ink cartridge, and a recording device, with the aim of optimizing a short-circuit detection scheme for a terminal on an ink cartridge chip.

The embodiments of the present invention provide an ink cartridge chip detachably mounted on an ink cartridge where the ink cartridge chip includes a circuit board, the circuit board is provided with a plurality of connecting terminals in contact connection with apparatus-side terminals of a recording device body, and the ink cartridge chip further includes:
at least one detecting terminal, arranged adjacent to the connecting terminals, each connecting terminal being configured to detect short circuit occurring between the detecting terminal and at least one connecting terminal adjacent to the detecting terminal, where the at least one detecting terminal is not in contact with the apparatus-side terminals.

The embodiments of the present invention also provide an ink cartridge including an ink cartridge body and an electrical component, and the ink cartridge further includes the ink cartridge chip according to any of the embodiments of the present invention, and the electrical component is arranged on the circuit board of the ink cartridge chip and/or the ink cartridge body.

The embodiments of the present invention also provide a recording device including a recording device body and an ink cartridge, and apparatus-side terminals are provided on the recording device body, where the ink cartridge adopts the ink cartridge according to any of the embodiments of the present invention, and when the ink cartridge is mounted to the recording device, the apparatus-side terminals are in one-to-one contact connection with the plurality of connecting terminals.

According to the technical solutions provided in the embodiments of the present invention, short circuit can be actively detected at the ink cartridge chip side in early stage after the ink cartridge is mounted to the recording device, and thus a possibility that the electrical component on the ink cartridge has been damaged when a short circuit is detected by the recording device is reduced, and moreover, for a recording device without a short-circuit detection circuit, ink cartridge application safety factor is also increased, preventing the recording device from failure without warning.

### BRIEF DESCRIPTION OF DRAWINGS

FIG. 1a is a schematic structural diagram of an ink cartridge to which the ink cartridge chip is applicable according to Embodiment 1;
FIG. 1b is a schematic structural diagram of arrangement of apparatus-side terminals in an inkjet printer applicable to the ink cartridge shown in FIG. 1a;
FIG. 1c is a front view of an ink cartridge chip according to Embodiment 1;
FIG. 1d is a side view of an ink cartridge chip according to Embodiment 1;
FIG. 1e is a circuit structure schematic diagram of an ink cartridge chip according to Embodiment 1;
FIG. 1f is a schematic structural diagram of corresponding installation between a printer and an ink cartridge according to Embodiment 1;
FIG. 2a is a schematic structural diagram of an ink cartridge chip according to Embodiment 1;
FIG. 2b is an enlarged schematic structural diagram of the detecting terminal in FIG. 2a;
FIG. 3a is a schematic structural diagram of an ink cartridge to which an ink cartridge chip is applicable according to Embodiment 2;
FIG. 3b is a schematic structural diagram of arrangement of apparatus-side terminals in an inkjet printer applicable to the ink cartridge shown in FIG. 3a;
FIG. 3c is a front-view schematic diagram of the ink cartridge chip according to Embodiment 2;
FIG. 3d is a side-view schematic diagram of the ink cartridge chip according to Embodiment 2;
FIG. 3e is a circuit schematic diagram of the ink cartridge chip according to Embodiment 2;
FIG. 4a is a schematic structural diagram of arrangement of apparatus-side terminals in an inkjet printer according to Embodiment 3 of the present invention;
FIG. 4b is a front-view structure schematic diagram of an ink cartridge chip provided according to Embodiment 3 of the present invention;
FIG. 4c is a side-view structure schematic diagram of an ink cartridge chip provided according to Embodiment 3 of the present invention;
FIG. 4d is a circuit schematic diagram of an ink cartridge chip provided according to Embodiment 3 of the present invention;
FIG. 5 is a schematic diagram of detection principle for detecting whether all the ink cartridges are mounted to the printer according to Embodiment 3 of the present invention;
FIG. 6 is a first schematic diagram of a connecting terminal of an ink cartridge chip according to an embodiment of the present invention;
FIG. 7 is a second schematic diagram of a connecting terminal of an ink cartridge chip according to an embodiment of the present invention;
FIG. 8 is a schematic structural diagram of a controllable switch in an ink cartridge chip according to Embodiment 4;
FIG. 9 is a flow chart of a short-circuit detection method of an ink cartridge chip according to Embodiment 6; and
FIG. 10 is a schematic structural diagram of a controllable switch in an ink cartridge chip according to Embodiment 5.

### DESCRIPTION OF EMBODIMENTS

Common recording devices include various devices which record image or text on paper, such as a laser printer and an ink jet printer, and accordingly, common ink cartridges include an ink cartridge for accommodating ink, a toner cartridge for accommodating toner, and the like. For the sake of simplifying the description and clearly presenting technical solutions, hereinafter, an ink jet printer and an inkjet ink cartridge are taken as examples, to explain the technical solutions of the embodiments of the present invention in details with reference to the accompanying drawings. It will be appreciated by persons skilled in the art, the solutions of the embodiments below similarly apply to other types of containers for accommodating printing materials and corresponding recording devices, and likewise, the ink cartridge also can be other containers for accommodating printing materials, such as a toner cartridge.

### Embodiment 1

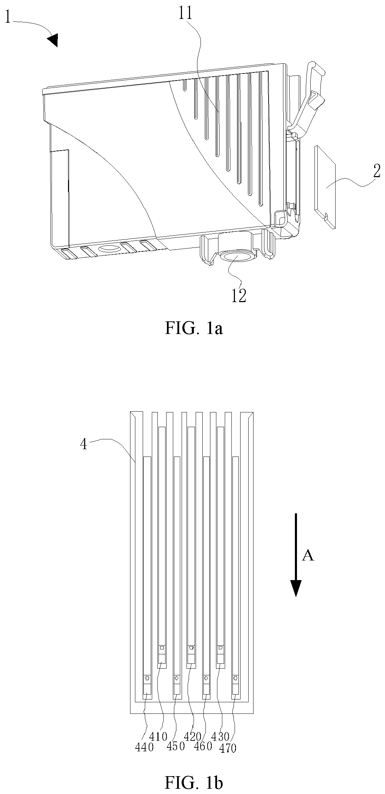

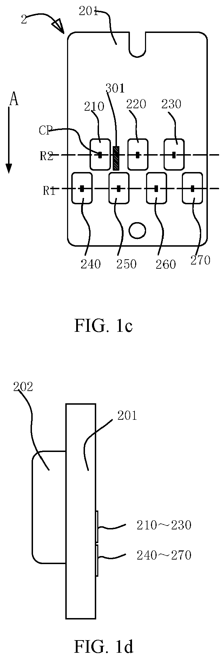

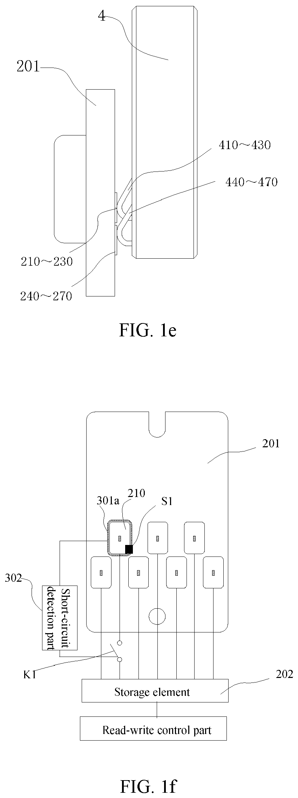

FIG. 1a is a schematic structural diagram of an ink cartridge to which the ink cartridge chip is applicable according to Embodiment 1 of the present invention, FIG. 1b is a schematic structural diagram of arrangement of apparatus-side terminals in an inkjet printer applicable to the ink cartridge shown in FIG. 1a, FIG. 1c is a front view of an ink cartridge chip according to Embodiment 1 of the present invention, FIG. 1d is a side view of an ink cartridge chip according to Embodiment 1 of the present invention, FIG. 1e is a circuit structure schematic diagram of an ink cartridge chip according to Embodiment 1 of the present invention, and FIG. 1f is a schematic structural diagram of corresponding installation between a printer and an ink cartridge according to Embodiment 1 of the present invention.

In order to install a plurality of ink jet ink cartridges, an ink jet printer is often provided with a plurality of ink cartridge mounting portions, and each ink cartridge mounting portion is provided with an ink supply needle that is connected to the print head of the ink jet printer, for delivering ink sucked from the ink jet ink cartridge to the print head. Moreover, each ink cartridge mounting portion is provided with a contact mechanism 4. As shown in FIG. 1b, the contact mechanism 4 is formed with a plurality of apparatus-side terminals, and seven terminals are taken as an example in this embodiment. The seven apparatus-side terminals 410-470 in the contact mechanism 4 are arranged in an inserting direction A along which the ink cartridge is inserted into the printer at a given interval in two rows perpendicular to the inserting direction A.

As shown in FIG. 1a, an ink cartridge 1 includes: an ink cartridge body 11 for storing printing ink; an ink supply part 12, formed on the bottom wall of the ink cartridge body 11, and connected with an ink supply pipe after the ink cartridge 1 is mounted to an inkjet printer, for delivering ink sucked from the ink cartridge body 11 to a print head; ink cartridge chip 2, detachably mounted on an outer wall of the ink cartridge body 11, and located in a position opposite to the contact mechanism 4 after the ink cartridge 1 is mounted to the inkjet printer.

The ink cartridge chip 2 provided in this embodiment is detachably mounted on the ink cartridge, and the ink cartridge chip 2 includes a circuit board 201 that is provided with at least two connecting terminals in contact connection with apparatus-side terminals of a recording device body. The ink cartridge chip 2 also includes a detecting terminal 301 provided on the circuit board 201, and arranged adjacent to and spaced apart from the connecting terminal at a predetermined interval; a short-circuit detection part 302 electrically connected with the detecting terminal 301 and/or the connecting terminal, and configured to judge whether a short circuit occurs between the detecting terminal 301 and the connecting terminal according to a change in an electrical signal of the detecting terminal 301 and/or the connecting terminal; and a short-circuit control part connected with the short-circuit detection part 302, to execute a short-circuit abnormality processing when short circuit is detected.

Particularly, as shown in FIG. 1c, the surface provided with the connecting terminal is a surface exposed to the outside when the circuit board 201 is mounted to the ink cartridge body 11. Electrical components may be provided on the circuit board 201, or the ink cartridge body 11, and are electrically connected with the connecting terminals, and the connecting terminals are connected with the apparatus-side terminals when the ink cartridge is inserted into the printer, so as to transmit signals between the electrical components and the printer. In this embodiment, description will be made by taking an example where the electrical component is a storage element 202 provided on the circuit board 201 and has seven connecting terminals 210-270. As shown in FIG. 1c and FIG. 1d, the storage element 202 is disposed on the back face of the circuit board 201, a terminal group consisting of the seven connecting terminals 210-270 is disposed on the front face of the circuit board 201, and the seven connecting terminals 210-270 above are in one-to-one contact with the seven apparatus-side terminals 410-470 of the printer, as shown in FIG. 1e. Where, the storage element 202 may be storage medium with various properties such as EEPROM, RAM+ battery and FLASH, which is mainly used to store ink cartridge related information, such as ink residual quantity and ink type. The seven connecting terminals 210-270 are all connected with the storage element 202, and usually configured in a rectangular shape, and preferably, are arranged in an inserting direction A along which the ink cartridge is inserted into the printer at a given interval in two rows perpendicular to the inserting direction A, where the row nearer the ink supply part 12 in the inserting direction A is recorded as a lower side row R1, and the other row farther from the ink supply part 12 is recorded as an upper side row R2. As seen from arrangement of the connecting terminals in FIG. 1c, the terminals arranged on the upper side low R2 from left to right are: a power supply terminal (VCC) 210, a reset terminal (RST) 220 and a read-write (W/O) terminal 230; the terminals arranged on the lower side low R1 from left to right are: a clock terminal (CLK) 240, a first ground terminal (GND) 250, a second ground terminal (GND) 260 and an input/output terminal (I/O) 270. Furthermore, the connecting terminals 210-230 forming the upper side row R2 and the connecting terminals 240-270 forming the lower side R1 are staggered with respect to each other, so that the centers of the connecting terminals are not aligned with respect to each other in the inserting direction. As described above, the seven connecting terminals 210-270 are in one-to-one contact with the seven apparatus-side terminals 410-470, and thus contact portions (CP) for contacting respective apparatus-side terminals 410-470 are formed at the center of each of the connecting terminals 210-270, and therefore the contact portions forming on the upper side row R2 and the contact portions forming on the lower side row R1 similarly form the so-called staggered arrangement.

In this embodiment, in order to reduce short circuit damage to the printer or the ink cartridge chip on some printer without the short-circuit detection circuit, it is proposed in this embodiment that, by enabling the ink cartridge chip to independently and initiatively detect whether short circuit occurs thereon, the printer can timely discover there is abnormality on the ink cartridge chip, and remind the user to timely examine the ink cartridge chip, avoiding damage to the circuit or the ink cartridge chip inside the printer.

To this end, in this embodiment, in addition to the connecting terminal, the circuit board is further provided with a detecting terminal and a short-circuit detection part connected with the detecting terminal and/or the connecting terminal. Where, the number of the detecting terminal is one or more, the detecting terminals is arranged adjacent to any one or more connecting terminals and all not in contact with the plurality of apparatus-side terminals. The short-circuit detection part may be configured to detect whether short circuit occurs between any detecting terminal and its adjacent connecting terminal. The short-circuit control part can execute abnormality processing after receiving a detection result of the short-circuit detection part, to avoid damage to the ink cartridge chip, or cause the printer to prompt an error, such as "ink cartridge installation abnormal", "ink cartridge short circuit", and thus the printer fails to print, and the user needs to check or replace the ink cartridge.

Each detecting terminal may be configured in an arbitrary shape, as long as that it approaches the connecting terminal to be detected. Moreover, the detecting terminal may approach any direction of the connecting terminal to be detected, and when it is disposed in a certain direction, it can be used to detect short circuit between it and the connecting terminal in this direction. As shown in FIG. 1c, the detecting terminal is arranged on the right of the power supply terminal, and thus can detect short circuit occurred on the right of the power supply terminal. Therefore, in order to ensure the detecting terminal can detect short circuit in each direction of its adjacent terminals, preferably, the detecting terminal is arranged around the connecting terminal.

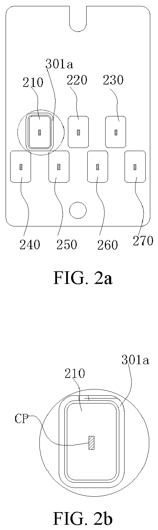

Particularly, FIG. 2a is a schematic structural diagram of an ink cartridge chip according to one embodiment of the present invention, and FIG. 2b is an enlarged schematic structural diagram of the detecting terminal shown in FIG. 2a. As shown in FIG. 2a and FIG. 2b, the detecting terminal 301a is annular in shape, surrounding the external side of the connecting terminal 210, and keeps a predetermined interval from the connecting terminal 210. The detecting terminal 301a is preferably arranged around the connecting terminal 210, which can be used to detect whether short circuit occurs in each direction of the connecting terminal.

When there is a larger voltage difference between connecting terminals, damage caused by short circuit will be greater, and thus preferably, the detecting terminal 301 is arranged between two connecting terminals, and keeps a predetermined interval from the two connecting terminals respectively, as shown in FIG. 1c. The detecting terminal 301 can be arranged between any two connecting terminals, especially two connecting terminals with a voltage difference, for detecting whether short circuit occurs between the connecting terminals, as shown in FIG. 1c, the detecting terminal 301 is arranged between a power supply terminal 210 and a reset terminal 220. It will be appreciated by persons skilled in the art, when the detecting terminal 301 is arranged between two adjacent terminals, the short circuit between the two adjacent terminals is prevented by detecting the short circuit between the detecting terminal 301 and any of the two adjacent terminals.

The shape of the detecting terminal in the above embodiments may be a curve or a straight line, as long as it can function as a short-circuit detection.

In the technical solutions of the embodiments of the present invention, the short-circuit detection part may judge occurrence of the short circuit according to a change in an electrical signal of the detecting terminal and/or the connecting terminal. The short-circuit detection part can be implemented by a hardware circuit. The short-circuit detection part may be provided on a circuit board, preferably connected with a voltage source, and form an electrical loop with the detecting terminal and/or the connecting terminal, to detect the change in the electrical signal. The voltage source can be provided additionally, or be a voltage source for detection by connecting with the power supply terminal.

There are many ways of forming the electrical loop for detection, for example, the short-circuit detection part is connected with the detecting terminal, which has no voltage or has a fixed voltage value in the initial state, and when short circuit between the detecting terminal and a adjacent connecting terminal occurs, the detecting terminal is applied with a certain voltage to cause a certain voltage or change of the fixed voltage value, and thereby short circuit may be detected. Alternatively, in the initial state, the short-circuit detection part may apply an electrical signal to one or two connecting terminals adjacent to the detecting terminal, and then detect whether the detecting terminal has an electrical signal or whether the returned electric signal is the preset value. Alternatively, the short-circuit detection part may apply an electrical signal to the detecting terminal, and detect whether the electric signal returned by the detecting terminal satisfies the preset value. Furthermore, the short-circuit detection part also may apply electrical signals to all the connecting terminals in sequence, and detect a change in the electrical signal of the detecting terminal when the electrical signal is applied at every time, so as to judge which connecting terminal is short circuited with the detecting terminal. It will be appreciated by persons skilled in the art, the above detection manners may be used separately or jointly.

In embodiments of the present invention, there are many ways of executing a short-circuit abnormality processing by the short-circuit control part, and there are many ways of causing the printer to prompt an error. For example, an error signal may be transmitted to the printer; or, when the printer control circuit can recognize the detection result, the detection result can be transmitted directly to the printer side; or the signal transmission channel between the chip and the printer side is disconnected, to make the chip signal cannot be transmitted to the printer side.

The short-circuit control part can implement in many ways. For example, the short-circuit control part may include a control unit and a controllable switch, the control unit may be implemented by hardware or software, and connected with the short-circuit detection part, to switchably control closing or opening of the controllable switch under the control of the detection result whether short circuit occurs.

Particularly, the above control unit and the controllable switch may be two components independent from each other, for example, the control unit may be an integrated circuit for receiving the detection result of the short-circuit detection part and making judgment.

Alternatively, the short-circuit control part may be a controllable switch, the controllable switch is connected with the short-circuit detection part, so that it can be switchably closed or opened under the control of a detection result whether short circuit occurs.

For example, the short-circuit control part may be a break relay that usually is in a normally closed state, and when the short-circuit detection part detects that short circuit occurs, the break relay is switched into an "OFF" state by delivering the current.

For example, as shown in FIG. 1f, if a controllable switch K1 is used as a short-circuit control part, then the controllable switch K1 is connected with the short-circuit detection part 302, so that it can be switchably closed or opened under the control of a detection result whether short circuit occurs. It will be appreciated by persons skilled in the art, at this time, the controllable switch K1 may be a switch, ON/OFF of which is directly controlled by an electrical signal, and also may be an integrated circuit with a judging function to control ON and OFF of the switch after the short circuit detection result is recognized.

The purpose of arranging the above controllable switch is in that, on the one hand, the electrical structure is simple and easy to control, and if a short circuit occurs, the electrical component of the ink cartridge can be protected by disconnecting the key circuit, and on the one hand, the controllable switch is arranged on the signal transmission channel between the ink cartridge and the printer, so as to report an error to the printer by cutting off signal transmission.

The electrical component in this embodiment is a storage element 202, and the controllable switch is connected in series between the storage element 202 and any one or more connecting terminals respectively, so as to avoid damage to the storage element 202 in case of a short circuit.

Furthermore, the ink cartridge chip may be further provided with a read-write control part different from the short-circuit control part and connected with the storage element, for allowing the printer to perform a read-write operation on the storage element in responsive to a control instruction of the printer side. Moreover, the short-circuit control part and the read-write control part either may be arranged independently from each other, or may be integrated with each other. Specifically, when the short-circuit control part is a controllable switch, the short-circuit control part and the read-write control part are independent from each other; when the control unit of the short-circuit control part and the controllable switch are arranged separately, the control unit and the read-write control part may be integrated into one device.

Generally, the storage element establishes an electrical connection with corresponding apparatus-side terminal at the printer side via the connecting terminal, and thus communicates with the printer. That is to say, the storage element is connected with the connecting terminal. Thus the controllable switch may be arranged on the connecting channel between the storage element and the connecting terminal, so as to connect or disconnect the communication between the storage element and the printer according to the detection result of the short-circuit detection part, and therefore, when short circuit occurs, the chip can execute an abnormality processing and cause the printer to prompt an error.

In this embodiment, since all the connecting terminals in the terminal group establish the electrical connection with the storage element, that is, the storage element establishes the electrical connection with the apparatus-side terminal via all the connecting terminals, so as to communicate with the printer, a controllable switch may be arranged between any of the connecting terminals in the terminal group and the storage element in this embodiment, so as to selectively connect or disconnect the signal transmission channel between the chip and the printer. It will be appreciated by persons skilled in the art, in order to multiply protect safety of the chip, a plurality of detecting terminals, and a plurality of controllable switches may be arranged.

Preferably, in this embodiment, the connecting terminal connected with the storage element may be a power supply terminal, a reset terminal, a read-write terminal, a clock terminal, a first ground terminal, a second ground terminal and an input/output terminal; then the detecting terminal is preferably arranged adjacent to the power supply terminal, the first ground terminal, or the second ground terminal. There may be three controllable switches, respectively arranged on channels of the power supply terminal, the first ground terminal, and the second ground terminal with the storage element.

Hereinafter, the principle of short-circuit detection of the ink cartridge chip 2 will be described fully with reference to the accompany drawing of this embodiment.

As shown in FIG. 1e, ink S1 drops between a power supply terminal 210 and a detecting terminal 301, a switch K1 is arranged on a connecting line between the power supply terminal 210 and a storage element 202. In order to enable the printer to perform an initialization operation or a printing operation after confirming that there is no short circuit on the chip. In this embodiment, the switch K1 is preferably disconnected in an initial state. In order to simplify configuration of a short-circuit detection part 302, in this embodiment, the initial voltage of the detecting terminal 301 is preferably set as 0. As such, when the ink drop S1 or other conductive substance is deposited on a circuit board 201, bridging the power supply terminal 210 and the detecting terminal 301, then the voltage received by the power supply terminal 210 via the apparatus-side terminals 410-470 will be applied to the detecting terminal 301. When the short-circuit detection part 302 monitors the voltage of the detecting terminal 301 becomes non-zero, it can judge a short circuit occurs between itself and the power supply terminal 210, and sends the detection result to the switch K1, to maintain the switch K1 in an OFF state. The storage element 202 fails to start for not receiving the power supply, then the printer always fails to establish an communication channel with the storage element 202, that is, the printer always fails to perform a read-write operation on the storage element 202, and then the printer prompts an error. On the contrary, if the short-circuit detection part 302 doesn't monitor a change in the voltage of the detecting terminal 301, that is, the voltage of the detecting terminal 301 maintains 0, then the short-circuit detection part 302 controls the switch K1 to connect, that is, the printer and the storage element 202 can communicate normally.

It will be appreciated by persons skilled in the art, the detecting terminal also can detect a short circuit between itself and the first ground terminal/the second ground terminal, it only needs to change the arrangement position and the preset value of the detecting terminal; the switch K1 also can be arranged between the storage element and the remaining connecting terminals, such as a clock terminal, a first ground terminal, or a second ground terminal, as long as the signal transmission channel between the storage element and the apparatus-side terminal of the printer can be changed.

By adopting the above technical solutions, short circuit can be actively detected at the ink cartridge chip side in early stage after the ink cartridge is mounted to the recording device, and thus a possibility that the electrical component on the ink cartridge has been damaged when a short circuit is detected by the recording device is reduced, and moreover, for a recording device without a short-circuit detection circuit, ink cartridge application safety factor is also increased, preventing the recording device from failing without warning.

### Embodiment 2

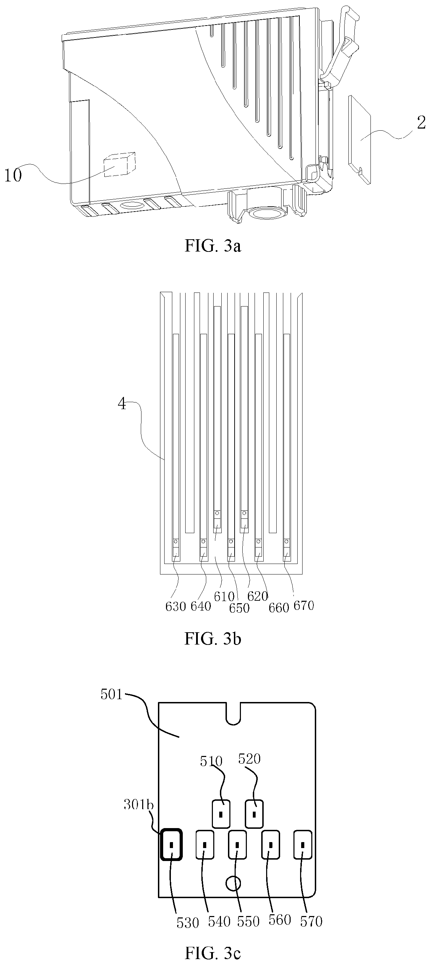

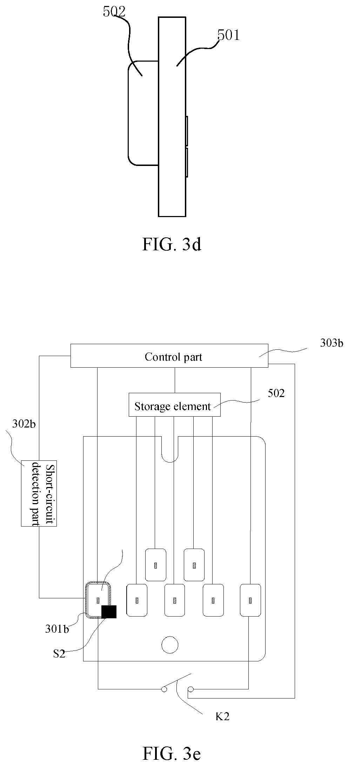

FIG. 3a is a schematic structural diagram of an ink cartridge to which an ink cartridge chip is applicable according to Embodiment 2 of the present invention, FIG. 3b is a schematic structural diagram of arrangement of apparatus-side terminals in an inkjet printer applicable to the ink cartridge shown in FIG. 3a, FIG. 3c is a front-view schematic diagram of the ink cartridge chip according to Embodiment 2 of the present invention, FIG. 3d is a side-view schematic diagram of the ink cartridge chip according to Embodiment 2 of the present invention, and FIG. 3e is a circuit schematic diagram of the ink cartridge chip according to Embodiment 2 of the present invention.

In Embodiment 2 of the present invention, the control unit of the short-circuit control part integrates with the read-write control part, to be called as "control part", i.e., the control part 303b as shown in FIG. 3e. Apparently, a controllable switch K2 and the control unit are arranged separately, and connect with the control part 303b.

In Embodiment 2 of the present invention, there are two types of electrical components, a first electrical component and a second electrical component, respectively, and the first electrical component has a drive voltage lower than the second electrical component. There are two types of connecting terminals, a first connecting terminal connected with the first electrical component, and a second connecting terminal connected with the second electrical component, respectively. The detecting terminal is arranged between the first connecting terminal and the second connecting terminal. In this embodiment, the detecting terminal is arranged between different connecting terminals corresponding to the electrical components with different drive voltages, so that it can more effectively avoid damage of a high voltage to the electrical components in case of a short circuit.

In this embodiment, preferably, the number of the second connecting terminals is at least two, the controllable switch is connected in series between two second connecting terminals, for changing signals through switchable opening or closing that is transmitted by the second electrical component to the recording device body. Different from Embodiment 1, the controllable switch not only can be arranged between the connecting terminal and any electrical component, to change the signal transmission channel between the electrical component and the recording device body, but also can be arranged between more than two connecting terminals, to change the signal transmission channel.

In this embodiment, a storage element 502 is still disposed on a circuit board 501, the second electrical component can be provided on the ink cartridge body 11, or on the chip, which can be selected according to specific needs. Correspondingly, in addition to a plurality of first connecting terminals 530, 570 connected with the storage element 502, the chip is further provided with a plurality of second connecting terminals 510, 520, 540-560 connected with the second electrical component, and the plurality of second connecting terminals 510, 520, 540-560 are also in contact with corresponding apparatus-side terminals 610, 620, 640-660 of the printer side to establish electrical connections. Because there is a voltage difference between the second electrical component and the storage element 502, if a short circuit between the first connecting terminal and the second connecting terminal occurs, then the second electrical component or the storage element 502 may be damaged.

In this embodiment, in order to prewarn short circuit between the two electrical components as early as possible, preferably, the detecting terminal 301b is arranged between two adjacent connecting terminals connected with different electrical components, and in this way, since the second electrical component communicates with the printer via corresponding connecting terminal, in this case, the controllable switch for connecting or disconnecting communication between the chip and the printer may not only be arranged between the storage element 502 and its corresponding connecting terminals, but also between the second electrical component and its corresponding connecting terminals. Moreover, when two ends of the second electrical component are connected with two connecting terminals respectively, the controllable switch also can be arranged between two second connecting terminals, or, a signal output by the second electrical component to the printer is directly modified as an error signal, so that the chip can execute an abnormality processing and then the printer reports an error.

In this embodiment, description will be made by taking an example where the first electrical component is the storage element 502, and the second electrical component is a piezoelectric sensor 10, the piezoelectric sensor is particularly used to detect the real-time ink level.

As shown in FIG. 3a, the ink cartridge body 11 is provided with the piezoelectric sensor 10. The plurality of apparatus-side terminals 610-670 at the printer side are also arranged in two rows along the inserting direction A of the ink cartridge, and correspondingly, two rows of connecting terminals are arranged on the circuit board 501 of the chip in the same arrangement, wherein, a reset terminal 510, a clock terminal 520, a first ground terminal 540, a power supply terminal 550, and a data terminal (I/O) 560 are all connected with the storage element 502, while a first sensor terminal 530 and a second sensor terminal 570, which act as the second connecting terminal, are connected with the piezoelectric sensor 10, and are located at two ends of the front row relative to the inserting direction A. In addition, the working voltage of the piezoelectric sensor 10 when detecting the ink level is about 36V, which is far higher than the drive voltage 3.6V of the storage element 502.

After the ink cartridge with the above structure is mounted to the printer, the printer needs to access the storage element 502, and also needs to apply a voltage (which may be the working voltage 36V, or a lower voltage, such as 5V) to the piezoelectric sensor 10, so as to detect whether a preset reply signal can be received, and thereby determine whether the piezoelectric sensor 10 is normal. Only when the above two operations are normal, the printer considers the ink cartridge can use normally, otherwise, the printer considers the ink cartridge is abnormal, and prompts an error.

In this embodiment, the controllable switch K2 is arranged between the first sensor terminal 530 and the second sensor terminal 570 based on the above preset conditions, and the controllable switch K2 is disconnected in an initial state. As shown in FIG. 3e, when ink S2 drops between the first sensor terminal 530 and the detecting terminal 301b, the high voltage applied by the printer to the first sensor terminal 530 via the apparatus-side terminals 410-470 will be applied to the detecting terminal 301b, to change the electrical signal of the detecting terminal 301b, and thereby the short-circuit detection part 302b judges a short circuit occurs, and transmits the detection result to the control part 303b to control the controllable switch K2 to maintain OFF state, so that the piezoelectric sensor 10 cannot feed back a signal to the printer, and the printer prompts an error.

It will be appreciated by persons skilled in the art, if the electrical component is an analog circuit, that is, a signal with a specific frequency is always transmitted to the printer, then a false signal different from the signal with the specific frequency may be prestored, and when the short-circuit detection part 302b detects a short circuit between the detecting terminal 301b and a high voltage terminal or a low voltage terminal occurs, the control part transmits the prestored false signal to the printer, causing the printer to report an error.

### Embodiment 3

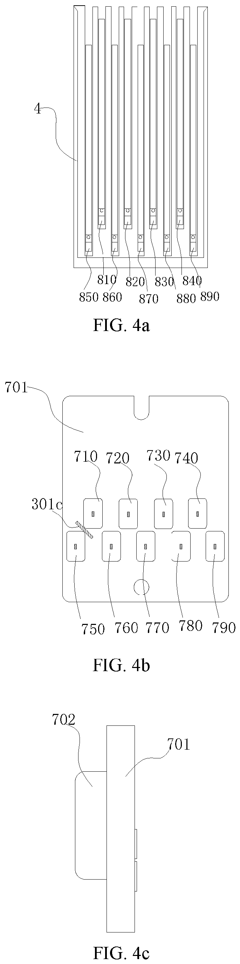

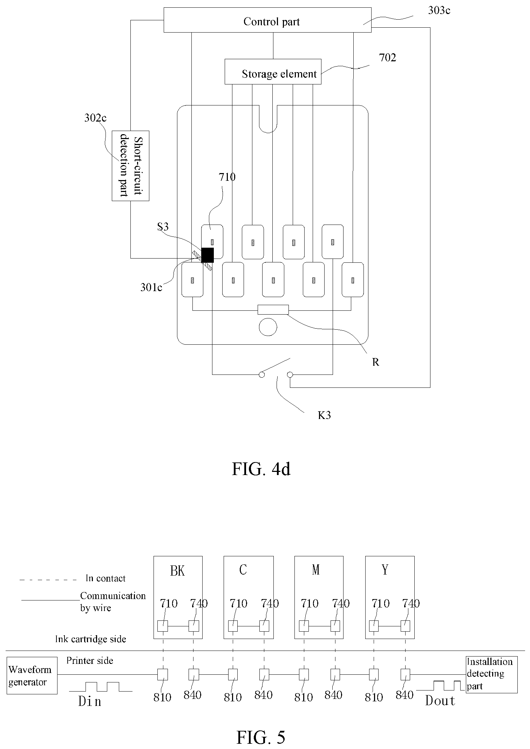

FIG. 4a is a schematic structural diagram of arrangement of apparatus-side terminals in an inkjet printer according to Embodiment 3 of the present invention, FIG. 4b is a front-view structure schematic diagram of an ink cartridge chip provided according to Embodiment 3 of the present invention, FIG. 4c is a side-view structure schematic diagram of an ink cartridge chip provided according to Embodiment 3 of the present invention, and FIG. 4d is a circuit schematic diagram of an ink cartridge chip provided according to Embodiment 3 of the present invention.

In Embodiment 3 of the present invention, there are two types of connecting terminals, an installation detecting connecting terminal, and an electrical connecting terminal connected with the electrical component, respectively. The detecting terminal is arranged between the installation detecting connecting terminal and the electrical connecting terminal.

The installation detecting connecting terminal, which is usually used for detecting short circuit of the connecting terminal on the chip by the recording device, arranged on the circuit board, and arranged adjacent to other electrical connecting terminals, to detect whether short circuit between the installation detecting connecting terminal and the adjacent connecting terminal occurs, and return the detection result to the recording device, so that the recording device can detect whether there is short circuit on the ink cartridge.

Preferably, the number of the installation detecting connecting terminal is two, 710 and 740, the controllable switch K3 is connected in series between the two installation detecting connecting terminals 710 and 740, for changing installation signals transmitted by the installation detecting connecting terminals 710, 740 to the recording device body through switchable opening or closing.

As shown in FIG. 4a, in this embodiment, the printer side is provided with a short-circuit detection circuit, at least one first apparatus-side terminals 820, 830, and 860-880, at least one second apparatus-side terminals 850 and 890 and at least one third apparatus-side terminals 810 and 840, and the at least one third apparatus-side terminals 810 and 840 are connected to the short-circuit detection circuit.

As shown in FIG. 4b-4d, in this embodiment, description will be made by taking an example where the electrical component includes a storage element 702 and a resistance R provided on a circuit board 701. The resistance R in working state will be applied with a high drive voltage, such as 42V. The storage element 702 has five first connecting terminals 720, 730 and 760-780, respectively contacting with first apparatus-side terminals 820, 830 and 860-880; the resistance R has two second connecting terminals 750 and 790, respectively contacting with second apparatus-side terminals 850 and 890; additionally, there are two installation detecting connecting terminals 710 and 740, respectively contacting with third apparatus-side terminals 810 and 840.

In general, the installation detecting connecting terminal is used to detect whether a short circuit occurs between the installation detecting connecting terminal and the second connecting terminal. When a short circuit occurs between the second connecting terminal and adjacent installation detecting connecting terminal, the short-circuit detection circuit of the printer can detect the occurrence of the short circuit according to voltage change of the third apparatus-side terminal or the second apparatus-side terminal, or the change in the output signal. However, since the short circuit detection is often performed when the printer has finished the initial detection, and thereby the performing is late, the storage element or other electrical component has been damaged when the short circuit is detected.

To avoid this, in this embodiment, the circuit board is additionally provided with a detecting terminal, a short-circuit detection part and a short-circuit control part, where the detecting terminal is arranged between the second connecting terminal and the installation detecting connecting terminal, and in this embodiment, the short-circuit control part integrates with the read-write control part, to be called as "control part", i.e., the control part 303c as shown in FIG. 4e. Apparently, the controllable switch K2 and the control unit are arranged separately, and connect with the control part 303b.

In this embodiment, in order to confirm ink cartridge mounting condition, in addition to the storage element access operation and sensor detection operation described in Embodiment 2, the printer often detects whether all the ink cartridges are loaded in the printer. FIG. 5 is a schematic diagram of detection principle for detecting whether all the ink cartridges are mounted to the printer according to Embodiment 3 of the present invention. The detection principle of the printer will be described below with reference to FIG. 5 and by taking an example where the printer side is loaded with four ink cartridges, i.e., black (BK), cyan (C), magenta (M) and yellow (Y) ink cartridges.

As shown in FIG. 5, each ink cartridge is provided with the two installation detecting connecting terminals 710, 740, which respectively connect with the third apparatus-side terminals 810, 840 of the printer side, and the two installation detecting connecting terminals 710 and 740 in each ink cartridge are communicated via a wire. As known from FIG. 5, the second installation detecting connecting terminal 740 for ink cartridge n and the first installation detecting connecting terminal 710 for ink cartridge n+1 are connected with each other via corresponding third apparatus-side terminals 810, 840, where n=1, 2 or 3. The first installation detecting connecting terminal 710 for the first ink cartridge is connected with a waveform generator of the printer side, and the second installation detecting connecting terminal 740 for the fourth ink cartridge is connected with an installation detecting part provided at the printer side. If all the ink cartridges are properly mounted on the ink cartridge mounting portion of the printer, then the waveform generator and the installation detecting part are connected with each other via the installation detecting connecting terminal of each ink cartridge in sequence. As such, as long as there is one ink cartridge failing to mount or mounted badly, one of the third apparatus-side terminals or one of the installation detecting connecting terminals of the ink cartridge will not be contacted or is in bad contact, and thereby the waveform generator and the installation detecting part are in disconnected state. Hereby, the installation detecting part can judge whether all the ink cartridges are mounted, whether each installation detecting connecting terminal of each ink cartridge is not contacted or in bad contact, according to whether a response signal Dout corresponding to a detection signal Din transmitted from the waveform generator is received or not.

As known from the above principle, and as shown in FIG. 4d, when the short-circuit detection part 302 detects a short circuit occurs between the detecting terminal 301c and the installation detecting connecting terminal or the second connecting terminal, and the communication between the printer and the ink cartridge needs to be interrupted, in addition to that the controllable switch is arranged between the storage element and any first connecting terminal or between two second connecting terminals, as described in Embodiment 1 or 2, a controllable switch K3 may be arranged between two installation detecting connecting terminals 710 abd 740. As such, when ink S3 is adhered to the installation detecting connecting terminal 710 and the detecting terminal 301c, the short-circuit detection part 302, after detecting occurrence of this short circuit, controls the controllable switch K3 to be disconnected, and thereby the installation detecting part at the printer side cannot receive corresponding output signal Dout within a specified time period, and then thinks the installation of the ink cartridge is abnormal and thus prompts an error, causing the user to detect the ink cartridge again.

It will be appreciated by persons skilled in the art, even if no installation detecting part as shown in FIG. 5 is provided on the printer side, if the two installation detecting connecting terminals are still communicated with each other to feed back a signal to the printer, then the above controllable switch can likewise be arranged between the two installation detecting connecting terminals.

It will be appreciated by persons skilled in the art, if the chip is only provided with one installation detecting connecting terminal, and when the installation detecting connecting terminal is connected with other connecting terminal so as to perform ink cartridge installation detecting, the controllable switch also can be arranged between the installation detecting connecting terminal and the other connecting terminal, which means the other connecting terminal also acts as an installation detecting connecting terminal.

Based upon the above embodiment, it will be appreciated by persons skilled in the art, as for the storage element and its connecting terminals, the controllable switch may be arranged between any one or more connecting terminals and the storage element; as for two electrical components and respective connecting terminals, the controllable switch may be arranged between any one or more first connecting terminals and the storage element and/or between two second connecting terminals in series; as for two electrical components and installation detecting connecting terminals, the controllable switch may be arranged between any one or more connecting terminals and the storage element, between two second connecting terminals in series, and/or between two installation detecting connecting terminals in series. The position of the controllable switch may be adjusted as desired.

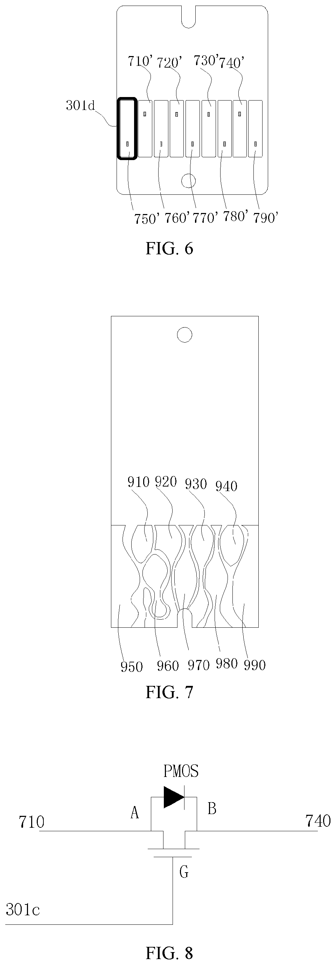

It will be appreciated by persons skilled in the art, provided that each connecting terminal in the terminal group is in contact with its corresponding apparatus-side terminal, the connecting terminals 710'-790' in the terminal group may be arranged in one row as shown in FIG. 6, the detecting terminal 301d surrounds the external side of the connecting terminal 710'; the connecting terminals 910-990 in the terminal group may be arranged in an irregular shape, as shown in FIG. 7 (detecting terminals are not shown).

It will be appreciated by persons skilled in the art, the ink cartridge chip can be arranged not only on an ink cartridge, but also on a structural body for containing an ink cartridge.

### Embodiment 4

FIG. 8 is a schematic structural diagram of a controllable switch in an ink cartridge chip according to Embodiment 4 of the present invention. The controllable switch in this embodiment is preferably a field effect transistor, where a control port of the field effect transistor is connected with a detecting terminal.

As shown in FIG. 8, the field effect transistor particularly is a PMOS transistor (P-type field effect transistor), and a control port of the PMOS transistor is connected with the detecting terminal 301c.

It will be appreciated by persons skilled in the art, the short-circuit detection part and the short-circuit control part may be made up of a hardware circuit. As shown in FIG. 8, taking Embodiment 3 as an example, a PMOS transistor as a short-circuit control part is arranged between two installation detecting connecting terminals 710 and 740, the PMOS transistor has three ports A, B and G, where the ports A and B are connected with the two installation detecting connecting terminals 710 and 740 respectively, and the control port G is connected with the detecting terminal 301c. Since the two installation detecting connecting terminals 710 and 740 are connected to the printer respectively via corresponding third apparatus-side terminals, and the two installation detecting connecting terminals 710 and 740 are connected with each other, the port A is equivalent to a signal input end of the printer, and the port B is equivalent to a signal output end of the printer. In this way, when the port A doesn't receive an electrical signal, an open circuit exists between the port A and the port B, on the contrary, when the port A receives an electrical signal, then the port A and the port B are communicated, and the two installation detecting connecting terminals 710 and 740 are communicated. In addition, when a short circuit between the detecting terminal 301c and the installation detecting connecting terminals 710, 740 occurs, that is, when the control port G is in high voltage level, communication between port A and B is cut off, that is, they both are disconnected. Apparently, the connection between the control port G of the PMOS transistor and the detecting terminal 301c is equivalent to the short-circuit detection part and the short-circuit control part. It will be appreciated by persons skilled in the art, the above hardware circuit also may be made up of other electrical components or logic circuits.

In the technical solutions in the embodiments of the present invention, the short-circuit control part also may be a signal transmitting unit, and is connected with the short-circuit detection part and the connecting terminal, so as to transmit a detection result or a short-circuit abnormality signal to a recording device body connected to the ink cartridge chip by the connecting terminal when short circuit is detected. The short-circuit abnormality signal may be obtained by changing the existing signal between the ink cartridge chip and the recording device body, also may be a false signal initiatively generated by the short-circuit control part or a prestored false signal, or may be recognized and reported an error by the recording device body when the short-circuit control part transmits the detection result of the short-circuit detection part to the recording device body.

The embodiments of the present invention also provide an ink cartridge including an ink cartridge body and an electrical component and further including the ink cartridge chip according to any of the embodiments of the present invention, wherein the electrical component is arranged on a circuit board of the ink cartridge chip and/or the ink cartridge body.

The embodiments of the present invention also provide a recording device including a recording device body and an ink cartridge, wherein the recording device body is provided with an apparatus-side terminal, and the ink cartridge is provided according to any of the embodiments of the present invention, when the ink cartridge is mounted to the recording device, the apparatus-side terminals are in one-to-one contact connection with the connecting terminals.

### Embodiment 5

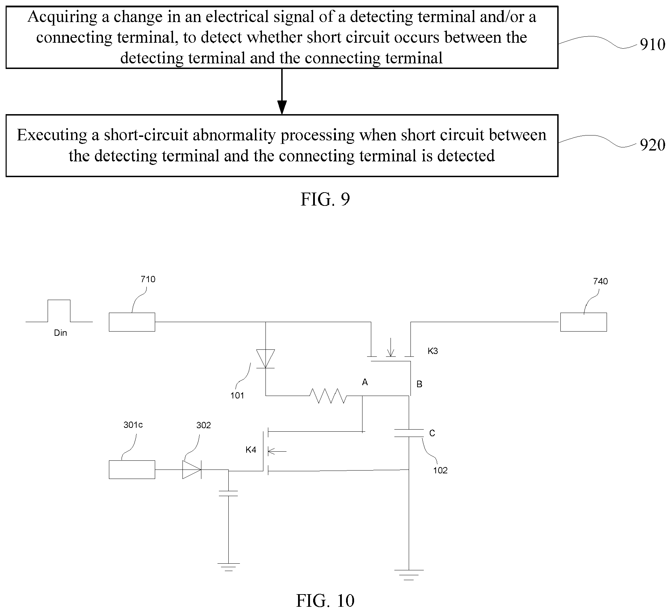

FIG. 10 is a schematic structural diagram of a controllable switch in an ink cartridge chip according to Embodiment 5 of the present invention. This embodiment is described by taking the controllable switch arranged between two installation detecting connecting terminals in the above embodiments as an example.

The short-circuit control part includes a control unit and a controllable switch, where the controllable switch is a first field effect transistor K3, which is connected in series between two installation detecting connecting terminals 710 and 740 by an input end and an output end, and the control unit includes a first diode 101, a first capacitor 102 and a second field effect transistor K4, the input end of the first field effect transistor K3 is connected to a control end via the first diode 101, the control end of the first field effect transistor K3 is grounded via the first capacitor 102, the second field effect transistor K4 is connected in series between the control end of the first field effect transistor K3 and the ground by an input end and an output end; the short-circuit detection part 302 is a second diode, and is connected to the control end of the second field effect transistor K4.

In this embodiment, the first field effect transistor K3 and the second field effect transistor K4 particularly are NMOS (N-type field effect transistor). As known from FIG. 10, when there is no short circuit on the chip, that is, the short-circuit detection part 302 doesn't detect a short circuit, the second field effect transistor K4 is in a disconnected state, and in this case, when the ink jet printer inputs a detection signal Din at the installation detecting connecting terminal 710 side, that is, the printer supplies power to the chip, point B of the control end of the first field effect transistor K3 becomes a high voltage level, the input end and the output end of the first field effect transistor K3 are communicated, that is, the two installation detecting connecting terminals 710, 740 are communicated with each other via the first field effect transistor K3, and the detection signal Din can be output from the installation detecting connecting terminal 740. To guarantee that point B is stabilized at a high voltage level all the time, preferably, point B is connected in series with the first capacitor 102, that is, when the printer supplies power to the chip, the first capacitor 102 is in an electrical storage state.

When there is short circuit on the detecting terminal 301c, the short-circuit detection part 302 is broken down, and the second field effect transistor K4 is closed, since the second field effect transistor K4 is grounded on one end thereof, which makes point A short-circuited with point B directly grounded, that is to say, at this time, the control end of the first field effect transistor K3 connected with point B turns from high voltage level to low voltage level, the first field effect transistor K3 is disconnected, and apparently, the two installation detecting connecting terminals 710 and 740 are unable to be connected with each other, that is, the detection signal Din cannot output via the installation detecting connecting terminal 740, thereby causing the printer to report an error and prompting the user to check the ink cartridge.

It will be appreciated by persons skilled in the art, the first field effect transistor K3 and the second field effect transistor K4 also may be PMOS, and then the first capacitor 102 can be omitted. In addition, the first diode 101 is set to prevent the current input from the terminal 710 from stable, and also can be omitted.

### Embodiment 6

FIG. 9 is a flow chart of a short-circuit detection method of an ink cartridge chip according to Embodiment 6 of the present invention, and the method can be executed on the basis of the ink cartridge chip provided in the above embodiments, and particularly includes:
Step 910, acquiring a change in an electrical signal of a detecting terminal and/or a connecting terminal, to detect whether short circuit occurs between the detecting terminal and the connecting terminal, wherein, the detecting terminal is provided on a circuit board of the ink cartridge chip, and arranged adjacent to and spaced apart from the connecting terminal provided on the circuit board at a predetermined interval;
Step 920, executing a short-circuit abnormality processing when short circuit between the detecting terminal and the connecting terminal is detected.

In the ink cartridge chip shown in Embodiment 1, the electrical component provided on the circuit board is a storage element, and a controllable switch is connected in series between the storage element and any one or more connecting terminals respectively. When short circuit between the detecting terminal and the connecting terminal is detected, the executing of the short-circuit abnormality processing preferably includes:
controlling the controllable switch to be open when short circuit between the detecting terminal and the connecting terminal is detected.

As the ink cartridge chip shown in Embodiment 2, there are two types of electrical components provided for the ink cartridge, a first electrical component and a second electrical component, respectively, and the first electrical component has a drive voltage lower than the second electrical component; there are two types of connecting terminals, a first connecting terminal connected with the first electrical component, and a second connecting terminal connected with the second electrical component, respectively; the detecting terminal is arranged between the first connecting terminal and the second connecting terminal; the number of the second connecting terminals is at least two, a controllable switch is connected in series between two second connecting terminals;
then, when short circuit between the detecting terminal and the connecting terminal is detected, the executing of the short-circuit abnormality processing particularly includes:
controlling the controllable switch to be open when short circuit between the detecting terminal and a second connecting terminal is detected, so as to change signals transmitted from the second electrical component to the recording device body.

As the ink cartridge chip shown in Embodiment 3, there are two types of connecting terminals, an installation detecting connecting terminal, and an electrical connecting terminal connected with the electrical component, respectively; the detecting terminal is arranged between the installation detecting connecting terminal and the electrical connecting terminal; the number of the installation detecting connecting terminal is two, a controllable switch is connected in series between the two installation detecting connecting terminals;
then, when short circuit between the detecting terminal and the connecting terminal is detected, the executing of the short-circuit abnormality processing particularly includes:
controlling the controllable switch to be open when short circuit between the detecting terminal and the second connecting terminal is detected, so as to change installation signals transmitted from the installation detecting connecting terminals to the recording device body.

When a short circuit between the detecting terminal and the connecting terminal is detected, operations for executing the short-circuit abnormality processing are not limited to the above few preferable manners. For example, when a short circuit between the detecting terminal and the connecting terminal is detected, transmit by the connecting terminal a detection result or an error signal to the recording device body; or when a short circuit between the detecting terminal and the connecting terminal is detected, disconnect the signal transmission channel between the ink cartridge chip and the recording device body.

Apparently, in the case of using the technical solutions according to the embodiments of the present invention, when the ink cartridge is mounted on the recording device, the chip thereon can perform short-circuit detection initiatively and independently, there is no need to provide a short-circuit detection circuit at the recording device side, and short-circuit detection can be performed at any time, such as before the recording device performs an initial detection on the chip, or when printing, so that damage to the recording device or devices on the ink cartridge due to later short-circuit detection can be avoided. Moreover, short-circuit detection also can be performed on the recording device available in the market and without the short-circuit detection circuit in real time, greatly improving safety of this kind of the recording device.

It will be appreciated by persons skilled in the art, all or some steps of the above method embodiments can be implemented by a program instruction related hardware. The program described above can be stored in a computer readable storage medium. When the program is executed, the steps in the above method embodiments are performed; the storage medium includes various media capable of storing program codes, such as a read only memory (ROM), a random access memory (RAM), a floppy disk, or an optical disk and the like.

Finally, it should be explained that the above embodiments are merely provided for describing the technical solutions of the present invention, but not intend to limit the present invention. It should be understood by persons skilled in the art that although the present invention has been described in detail with reference to the foregoing embodiments, modifications can be made to the technical solutions described in the foregoing embodiments, or equivalent replacements can be made to partial or all technical features in the technical solutions; however, such modifications or replacements do not cause the essence of corresponding technical solutions to depart from the scope of technical solutions of the embodiments of the present invention.

## Claims

1. An ink cartridge chip (2), detachably mounted on an ink cartridge (1), the ink cartridge chip (2) comprising a circuit board (701), the circuit board (701) being provided with a plurality of connecting terminals (710, 720, 730, 740, 750, 760, 770, 780, 790) in contact connection with apparatus-side terminals (810, 820, 830, 840, 850, 860, 870, 880, 890) of a recording device body, **characterized in that**, the ink cartridge chip (2) further comprises:
at least one detecting terminal (301c) provided on the circuit board (701), and arranged adjacent to the connecting terminals (710, 720, 730, 740, 750, 760, 770, 780, 790), each detecting terminal (301c) being configured to detect short circuit occurring between the detecting terminal (301c) and at least one connecting terminal (710, 720, 730, 740, 750, 760, 770, 780, 790) adjacent to the detecting terminal (301c) according to a change in an electrical signal of the detecting terminal (301c),
wherein the at least one detecting terminal (301c) is not in contact with the apparatus-side terminals (810, 820, 830, 840, 850, 860, 870, 880, 890).

2. The ink cartridge chip (2) according to claim 1, wherein at least two adjacent connecting terminals of the plurality of connecting terminals (710, 720, 730, 740, 750, 760, 770, 780, 790) have potential difference, and the at least one detecting terminal (301c) is arranged between the at least two adjacent connecting terminals.

3. The ink cartridge chip (2) according to claim 2, wherein the at least two adjacent connecting terminals comprise at least one connecting terminal (750, 790) applied with a high voltage, and at least one installation detecting connecting terminal (710, 740) for detecting ink cartridge mounting condition, and
the at least one detecting terminal (301c) is arranged between the at least one connecting terminal (750, 790) applied with a high voltage and the at least one installation detecting connecting terminal (710, 740), and is configured to detect short circuit occurring between the at least one detecting terminal (301c) and the at least one connecting terminal (750, 790) applied with a high voltage or the at least one installation detecting connecting terminal (710, 740).

4. The ink cartridge chip (2) according to any one of claims 1 to 3, wherein the at least one detecting terminal (301c) has no voltage or has a fixed voltage value in the initial state.

5. The ink cartridge chip (2) according to any one of claims 1 to 4, wherein the ink cartridge chip (2) further comprises:
a short-circuit detection part (302), electrically connected with the at least one detecting terminal (301c) and/or at least one of the plurality of connecting terminals (710, 720, 730, 740, 750, 760, 770, 780, 790), and configured to judge whether short circuit occurs between the at least one detecting terminal (301c) and the at least one of the plurality of connecting terminals (710, 720, 730, 740, 750, 760, 770, 780, 790) according to a change in an electrical signal of the at least one detecting terminal (301c) and/or the at least one of the plurality of connecting terminals (710, 720, 730, 740, 750, 760, 770, 780, 790).

6. The ink cartridge chip (2) according to claim 5, wherein the ink cartridge chip (2) further comprises:
a short-circuit control part, connected with the short-circuit detection part (302) and configured to execute a short-circuit abnormality processing when short circuit is detected.

7. The ink cartridge chip (2) according to claim 6, wherein
the short-circuit control part comprises a control unit and a controllable switch (K3), and the control unit is connected with the short-circuit detection part (302) and configured to switchably control closing or opening of the controllable switch (K3) under control of a detection result whether short circuit occurs; or
the short-circuit control part is a controllable switch (K3), and the controllable switch is connected with the short-circuit detection part (302) and configured to switchably close or open under control of a detection result whether short circuit occurs.

8. The ink cartridge chip (2) according to any one of claims 1 to 7, wherein the at least one detecting terminal (301c) is curve in shape.

9. The ink cartridge chip (2) according to any one of claims 1 to 7, wherein the at least one detecting terminal (301c) is annular in shape, surrounds an external side of the at least one connecting terminal (750, 790) applied with a high voltage, and keeps a predetermined interval from the at least one connecting terminal (750, 790) applied with a high voltage.

10. The ink cartridge chip (2) according to any one of claims 1 to 4, wherein the ink cartridge chip (2) further comprises a field effect transistor (K3), a control port (G) of the field effect transistor (K3) is connected with one of the at least one detecting terminal (301c), and the other two ports (A, B) of the field effect transistor (K3) are connected with two of the plurality of connecting terminals (710, 720, 730, 740, 750, 760, 770, 780, 790).

11. The ink cartridge chip (2) according to claim 10, wherein the control port (G) of the field effect transistor (K3) controls connection and disconnection of the other two ports (A, B) under control of a detection result whether short circuit occurs.

12. An ink cartridge (1), comprising an ink cartridge body (11) and an electrical component, and further comprising the ink cartridge chip (2) according to any one of claims 1 to 11, and the electrical component being arranged on the circuit board (701) of the ink cartridge chip (2) and/or the ink cartridge body (11).

13. A recording device, comprising a recording device body and an ink cartridge (1), apparatus-side terminals (810, 820, 830, 840, 850, 860, 870, 880, 890) being provided on the recording device body, wherein the ink cartridge (1) adopts the ink cartridge (1) according to claim 12, and when the ink cartridge (1) is mounted to the recording device, the apparatus-side terminals (810, 820, 830, 840, 850, 860, 870, 880, 890) are in one-to-one contact connection with the plurality of connecting terminals (710, 720, 730, 740, 750, 760, 770, 780, 790).

## Patentansprüche

1. Tintenpatronenchip (2), der abnehmbar an einer Tintenpatrone (1) angebracht ist, wobei der Tintenpatronenchip (2) eine Leiterplatte (701) umfasst, wobei die Leiterplatte (701) mit einer Vielzahl von Verbindungsanschlüssen (710, 720, 730, 740, 750, 760, 770, 780, 790) in Kontaktverbindung mit geräteseitigen Anschlüssen (810, 820, 830, 840, 850, 860, 870, 880, 890) eines Aufzeichnungsgerätekörpers versehen ist, **dadurch gekennzeichnet, dass** der Tintenpatronenchip (2) ferner umfasst:
mindestens einen Erfassungsanschluss (301c), der auf der Leiterplatte (701) vorgesehen und benachbart zu den Verbindungsanschlüssen (710, 720, 730, 740, 750, 760, 770, 780, 790) angeordnet ist, wobei jeder Erfassungsanschluss (301c) dazu konfiguriert ist, einen Kurzschluss zu erfassen, der zwischen dem Erfassungsanschluss (301c) und mindestens einem Verbindungsanschluss (710, 720, 730, 740, 750, 760, 770, 780, 790) benachbart zu dem Erfassungsanschluss (301c) auftritt, entsprechend einer Änderung in einem elektrischen Signal des Erfassungsanschlusses (301c),
wobei der mindestens eine Erfassungsanschluss (301c) nicht in Kontakt mit den geräteseitigen Anschlüssen (810, 820, 830, 840, 850, 860, 870, 880, 890) ist.

2. Tintenpatronenchip (2) nach Anspruch 1, wobei mindestens zwei benachbarte Verbindungsanschlüsse der Vielzahl von Verbindungsanschlüssen (710, 720, 730, 740, 750, 760, 770, 780, 790) eine Potentialdifferenz aufweisen und der mindestens eine Erfassungsanschluss (301c) zwischen den mindestens zwei benachbarten Verbindungsanschlüssen angeordnet ist.

3. Tintenpatronenchip (2) nach Anspruch 2, wobei die mindestens zwei benachbarten Verbindungsanschlüsse mindestens einen mit einer Hochspannung beaufschlagten Verbindungsanschluss (750, 790) und mindestens einen Installationserkennungs-Verbindungsanschluss (710, 740) zum Erkennen des Tintenpatronen-Montagezustands umfassen, und
wobei der mindestens eine Erfassungsanschluss (301c) zwischen dem mindestens einen mit einer Hochspannung beaufschlagten Verbindungsanschluss (750, 790) und dem mindestens einen Installationserkennungs-Verbindungsanschluss (710, 740) angeordnet und so konfiguriert ist, dass er einen Kurzschluss erfasst, der zwischen dem mindestens einen Erfassungsanschluss (301c) und dem mindestens einen mit einer Hochspannung beaufschlagten Verbindungsanschluss (750, 790) oder der mindestens einen Installationserkennungs-Verbindungsanschluss (710, 740) auftritt.

4. Tintenpatronenchip (2) nach einem der Ansprüche 1 bis 3, wobei der mindestens eine Erfassungsanschluss (301c) im Ausgangszustand keine Spannung oder einen festen Spannungswert aufweist.

5. Tintenpatronenchip (2) nach einem der Ansprüche 1 bis 4, wobei der Tintenpatronenchip (2) ferner umfasst:
ein Kurzschlusserfassungsteil (302), das elektrisch mit dem mindestens einen Erfassungsanschluss (301c) und/oder mindestens einem der Vielzahl von Verbindungsanschlüssen (710, 720, 730, 740, 750, 760, 770, 780, 790) verbunden und so konfiguriert ist, dass es beurteilt, ob ein Kurzschluss zwischen dem mindestens einen Erfassungsanschluss (301c) und dem mindestens einen der Vielzahl von Verbindungsanschlüssen (710, 720, 730, 740, 750, 760, 770, 780, 790) auftritt, entsprechend einer Änderung in einem elektrischen Signal des mindestens einen Erfassungsanschlusses (301c) und/oder des mindestens einen der Vielzahl von Verbindungsanschlüssen (710, 720, 730, 740, 750, 760, 770, 780, 790).

6. Tintenpatronenchip (2) nach Anspruch 5, wobei der Tintenpatronenchip (2) ferner umfasst:
ein Kurzschluss-Steuerteil, das mit dem Kurzschlusserfassungsteil (302) verbunden und so konfiguriert ist, dass es eine Kurzschluss-Abnormalitätsverarbeitung durchführt, wenn ein Kurzschluss erkannt wird .

7. Tintenpatronenchip (2) nach Anspruch 6, wobei
das Kurzschluss-Steuerteil eine Steuereinheit und einen steuerbaren Schalter (K3) umfasst, und die Steuereinheit mit dem Kurzschlusserfassungsteil (302) verbunden und so konfiguriert ist, dass sie schaltend das Schließen oder Öffnen des steuerbaren Schalters (K3) mittels Steuerung durch das Detektionsergebnis, ob ein Kurzschluss auftritt oder nicht, steuert; oder
wobei das Kurzschluss-Steuerteil ein steuerbarer Schalter (K3) ist, und der steuerbare Schalter mit dem Kurzschlusserfassungsteil (302) verbunden und so konfiguriert ist, dass er mittels Steuerung durch das Detektionsergebnis, ob ein Kurzschluss auftritt, schließt oder öffnet.

8. Tintenpatronenchip (2) nach einem der Ansprüche 1 bis 7, wobei der mindestens eine Erfassungsanschluss (301c) eine gekrümmte Form hat.

9. Tintenpatronenchip (2) nach einem der Ansprüche 1 bis 7, wobei der mindestens eine Erfassungsanschluss (301c) ringförmig ist, eine Außenseite des mindestens einen mit einer Hochspannung beaufschlagten Verbindungsanschlusses (750, 790) umgibt und einen vorbestimmten Abstand von dem mindestens einen mit einer Hochspannung beaufschlagten Verbindungsanschluss (750, 790) einhält.

10. Tintenpatronenchip (2) nach einem der Ansprüche 1 bis 4, wobei der Tintenpatronenchip (2) ferner einen Feldeffekttransistor (K3) umfasst, ein Steueranschluss (G) des Feldeffekttransistors (K3) mit einem der mindestens einen Erfassungsanschlüsse (301c) verbunden ist und die anderen beiden Anschlüsse (A, B) des Feldeffekttransistors (K3) mit zwei der mehreren Verbindungsanschlüsse (710, 720, 730, 740, 750, 760, 770, 780, 790) verbunden sind.

11. Tintenpatronenchip (2) nach Anspruch 10, wobei der Steueranschluss (G) des Feldeffekttransistors (K3) das Verbinden und Trennen der anderen beiden Anschlüsse (A, B) mittels Steuerung durch das Detektionsergebnis steuert, ob ein Kurzschluss auftritt.

12. Tintenpatrone (1), umfassend einen Tintenpatronenkörper (11) und ein elektrisches Bauteil, und ferner umfassend den Tintenpatronenchip (2) nach einem der Ansprüche 1 bis 11, wobei das elektrische Bauteil auf der Leiterplatte (701) des Tintenpatronenchips (2) und/oder des Tintenpatronenkörpers (11) angeordnet ist.

13. Aufzeichnungsvorrichtung mit einem Aufzeichnungsvorrichtungskörper und einer Tintenpatrone (1), wobei geräteseitige Anschlüsse (810, 820, 830, 840, 850, 860, 870, 880, 890) an dem Aufzeichnungsvorrichtungskörper vorgesehen sind, wobei die Tintenpatrone (1) die Tintenpatrone (1) gemäß Anspruch 12 annimmt, und wenn die Tintenpatrone (1) an der Aufzeichnungsvorrichtung angebracht ist, die geräteseitigen Anschlüsse (810, 820, 830, 840, 850, 860, 870, 880, 890) in Eins-zu-Eins-Kontaktverbindung mit der Mehrzahl von Verbindungsanschlüssen (710, 720, 730, 740, 750, 760, 770, 780, 790) stehen.

## Revendications

1. Puce de cartouche d'encre (2), montée de manière amovible sur une cartouche d'encre (1), la puce de cartouche d'encre (2) comprenant une carte de circuit (701), la carte de circuit (701) étant munie d'une pluralité de bornes de connexion (710, 720, 730, 740, 750, 760, 770, 780, 790) en connexion de contact avec des bornes côté appareil (810, 820, 830, 840, 850, 860, 870, 880, 890) d'un corps de dispositif d'enregistrement, **caractérisée en ce que** la puce de cartouche d'encre (2) comprend en outre :
au moins une borne de détection (301c) ménagée sur la carte de circuit (701), et agencée de manière adjacente aux bornes de connexion (710, 720, 730, 740, 750, 760, 770, 780, 790), chaque borne de détection (301c) étant conçue pour détecter un court-circuit se produisant entre la borne de détection (301c) et au moins une borne de connexion (710, 720, 730, 740, 750, 760, 770, 780, 790) adjacente à la borne de détection (301c) en fonction d'une variation dans un signal électrique de la borne de détection (301c),
**en ce que** ladite borne de détection (301c) n'est pas en contact avec les bornes côté appareil (810, 820, 830, 840, 850, 860, 870, 880, 890).

2. Puce de cartouche d'encre (2) selon la revendication 1, en ce qu'au moins deux bornes de connexion adjacentes de la pluralité de bornes de connexion (710, 720, 730, 740, 750, 760, 770, 780, 790) ont une différence de potentiel, et ladite borne de détection (301c) est agencée entre au moins deux bornes de connexion adjacentes.

3. Puce de cartouche d'encre (2) selon la revendication 2, en ce qu'au moins deux bornes de connexion adjacentes comprennent au moins une borne de connexion (750, 790) à laquelle est appliquée une haute tension, et au moins une borne de connexion de détection d'installation (710, 740) pour détecter une condition de montage de la cartouche d'encre, et
ladite borne de détection (301c) est agencée entre au moins une borne de connexion (750, 790) à laquelle est appliquée une haute tension et au moins une borne de connexion de détection d'installation (710, 740), et est conçue pour détecter un court-circuit se produisant entre ladite borne de détection (301c) et la ou les bornes de connexion (750, 790) à laquelle/auxquelles est/sont appliquée(s) une haute tension ou la ou les bornes de connexion de détection d'installation (710, 740).

4. Puce de cartouche d'encre (2) selon l'une des revendications 1 à 3, en ce que ladite borne de détection (301c) n'a pas de tension ou a une valeur de tension fixe à l'état initial.

5. Puce de cartouche d'encre (2) selon l'une des revendications 1 à 4, en ce que la puce de cartouche d'encre (2) comprend en outre :
une partie de détection de court-circuit (302), électriquement connectée à ladite borne de détection (301c) et/ou au moins à l'une de la pluralité de bornes de connexion (710, 720, 730, 740, 750, 760, 770, 780, 790), et conçue pour évaluer si un court-circuit se produits entre ladite borne de détection (301c) et au moins l'une de la pluralité de bornes de connexion (710, 720, 730, 740, 750, 760, 770, 780, 790) en fonction d'une variation dans un signal électrique de ladite borne de détection (301c) et/ou au moins de l'une de la pluralité de bornes de connexion (710, 720, 730, 740, 750, 760, 770, 780, 790).

6. Puce de cartouche d'encre (2) selon la revendication 5, en ce que la puce de cartouche d'encre (2) comprend en outre :
une partie de commande de court-circuit, connectée à la partie de détection de court-circuit (302) et conçue pour exécuter un processus de traitement d'anomalie de court-circuit lorsqu'un court-circuit est détecté.

7. Puce de cartouche d'encre (2) selon la revendication 6, en ce que
la partie de commande de court-circuit comprend une unité de commande et un commutateur commandable (K3), et l'unité de commande est connectée à la partie de détection de court-circuit (302) et conçue pour commander de manière commutable une fermeture ou une ouverture du commutateur commandable (K3) sous contrôle d'un résultat de détection si un court-circuit se produit ; ou
la partie de commande de court-circuit est un commutateur commandable (K3), et le commutateur commandable est connecté à la partie de détection de court-circuit (302) et conçu pour fermer ou ouvrir de manière commutable sous contrôle d'un résultat de détection si un court-circuit se produit.

8. Puce de cartouche d'encre (2) selon l'une des revendications 1 à 7, en ce que ladite borne de détection (301c) est de forme courbe.

9. Puce de cartouche d'encre (2) selon l'une des revendications 1 à 7, en ce que ladite borne de détection (301c) est de forme annulaire, entoure un côté externe de la ou des bornes de connexion (750, 790) à laquelle/auxquelles est/sont appliquée(s) une haute tension, et conserve un intervalle prédéterminé à partir de la ou des bornes de connexion (750, 790) à laquelle/auxquelles est/sont appliquée(s) une haute tension.

10. Puce de cartouche d'encre (2) selon l'une des revendications 1 à 4, en ce que la puce de cartouche d'encre (2) comprend en outre un transistor à effet de champ (K3), un port de commande (G) du transistor à effet de champ (K3) est connecté à ladite borne de détection (301c), et les deux autres ports (A, B) du transistor à effet de champ (K3) sont connectés à deux de la pluralité de bornes de connexion (710, 720, 730, 740, 750, 760, 770, 780, 790).

11. Puce de cartouche d'encre (2) selon la revendication 10, en ce que le port de commande (G) du transistor à effet de champ (K3) commande une connexion et une déconnexion des deux autres ports (A, B) sous contrôle d'un résultat de détection si un court-circuit se produit.

12. Cartouche d'encre (1), comprenant un corps de cartouche d'encre (11) et un composant électrique, et comprenant en outre la puce de cartouche d'encre (2) selon l'une des revendications 1 à 11, et le composant électrique est agencé sur la carte de circuit (701) de la puce de cartouche d'encre (2) et/ou du corps de cartouche d'encre (11).

13. Dispositif d'enregistrement, comprenant un corps de dispositif d'enregistrement et une cartouche d'encre (1), des bornes côté appareil (810, 820, 830, 840, 850, 860, 870, 880, 890) étant ménagées sur le corps de dispositif d'enregistrement, en ce que la cartouche d'encre (1) adopte la cartouche d'encre (1) selon la revendication 12, et lorsque la cartouche d'encre (1) est montée sur le dispositif d'enregistrement, les bornes côté appareil (810, 820, 830, 840, 850, 860, 870, 880, 890) sont en connexion de contact un à un avec la pluralité de bornes de connexion (710, 720, 730, 740, 750, 760, 770, 780, 790).
